# EUROPEAN PATENT SPECIFICATION

(11) **EP 1 234 133 B1**
(45) Date of publication and mention of the grant of the patent: **10.11.2004**
(21) Application number: 00982295.8
(22) Date of filing: 29.11.2000
(51) Int. Cl.: F16K 51/02

(54) **COMPACT GATE VALVE**
KOMPAKTES SCHIEBERVENTIL
VANNE DE PORTE COMPACTE

(30) Priority: 30.11.1999 US 451664
(43) Date of publication of application: 28.08.2002
(73) Proprietor: Wafermasters, Incorporated, San Jose, CA 95112 (US); TOKYO ELECTRON LIMITED, Minato-ku, Tokyo 107-8481 (JP)
(72) Inventor: YOO, Woo, Sik, Palo Alto, CA 94303 (US); KURIBAYASHI, Hiromitsu, Teine-ku, Sapporo-shi Hokkaido (JP)
(74) Representative: Freeman, Jacqueline Carol
(86) International application number: PCT/US2000/032563
(87) International publication number: WO 2001/040692

(56) References cited:
- EP-A- 0 665 193
- US-A- 4 328 947
- US-A- 4 446 815
- US-A- 4 613 111
- US-A- 4 921 213
- US-A- 5 013 009
- US-A- 5 363 872
- US-A- 5 820 104

## Description

### BACKGROUND OF THE INVENTION

### 1. Field of the Invention

This invention generally relates to semiconductor manufacturing equipment and, more particularly, to a gate valve for use with a rapid thermal processing reactor.

### 2. Description of the Related Art

In the semiconductor industry, to continue to make advancements in the development of semiconductor devices, especially semiconductor devices of decreased dimensions, new processing and manufacturing techniques have been developed. One such processing technique is know as Rapid Thermal Processing (RTP), which reduces the amount of time that a semiconductor device is exposed to high temperatures during processing. The RTP technique, typically includes irradiating the semiconductor device or wafer with sufficient power to quickly raise the temperature of the wafer and hold it at that temperature for a time long enough to successfully perform a fabrication process, but which avoids such problems as unwanted dopant diffusion that would otherwise occur at the high processing temperatures.

As is widely known in the semiconductor processing industry, processing techniques, such as RTP require fabrication clean room space to ensure that the processing is free from contaminants and particles that may reduce manufacturing precision. However, clean room space is expensive both to construct and maintain. Thus, semiconductor wafer processing systems which require large footprints are economically disadvantageous. Accordingly, processing system designers have attempted to construct systems having components with smaller, more compact, and narrower structures.

Of particular interest to the present invention, are gate valve structures, which are used in the processing system, for example, to isolate semiconductor wafers in various chambers, as they are being transported between locations of a first pressure to areas of a second pressure. Although the concept of isolating or sealing a chamber using gate valves is straightforward, the design of such valves can be complicated, especially due to competing design considerations. For example, the gate valve must provide adequate positive closure that can withstand process pressure and vacuum. Most often this need has been met using complicated linkages, that typically require both an axial and a lateral sealing action. For example, an apparatus is disclosed in U. S. Patent No. 4,721,282 where an initial axial motion of a shaft provides for the primary movement of a gate member toward a processing chamber port. A secondary lateral motion provides for movement of the gate member against the port for a positive seal.

For technological background, reference may be made to U.S. Patent Nos. 4,921,213,5,013,009, and 5, 820,104.

In the valve disclosed in U.S. Patent No. 4,921, 213, in the direction of the generatrices of the sealing surfaces, the sealing surface has an upper, middle and lower portion. The upper and lower portions each have an obtuse angle with the middle portion. The planes of the upper portion and middle portion extend almost perpendicularly to the sliding direction of the closing member.

In U.S. Patent No. 5,013,009 a cryogenic valve is disclosed, having a gate with a recess formed in one face of the gate. U. S. Patent No. 5,820,104 discloses a gate valve assembly, which includes a seal block having a contact surface substantially perpendicular to the direction of actuation.

For the above reasons, what is needed is a gate valve, which occupies a relatively small volume to maintain a small processor footprint and provides adequate isolation to the process chamber of a processing system during semiconductor processing.

### SUMMARY OF THE INVENTION

The present invention provides a gate valve assembly, which may be used to seal a semiconductor processing chamber to isolate the chamber and/or maintain pressure or vacuum therein. The invention includes a gate coupled to a linear axial shaft. The axial shaft is driven using a single linear action actuator. As described in greater detail below, the action refers to the movement of the gate valve assembly needed to move the gate into a gate seat. Thus, in the present invention the single action refers to the single axial movement of the shaft to provide the sealing function.

The gate of the present invention has an inclined surface to the shaft. The gate can be forced by the movement of the axial shaft against a similarly inclined gate seat surface. The inclined surface translates the axial sealing force, provided through the axial shaft, into a positive lateral sealing force without laterally moving the shaft or gate. The positive lateral sealing force pushes against seals, typically O-rings in the gate seal surface, to provide the seal. Advantageously, since the sealing is provided with a single axial action, the gate valve can be made smaller than other gate valves presently known in the art.

In one aspect of the present invention, a valve assembly is provided for use with a rapid thermal processing reactor. The valve assembly includes a main body, which defines a central axis. The assembly further includes a gate disposed within the main body, which has an inclined surface relative to the central axis of the main body. An actuation assembly is included in the valve assembly. The actuation assembly provides for linearly moving the gate through the main body along the central axis. The gate is moved between a first position, where the valve is open, and a second position, where the valve is closed.

In another aspect of the present invention, a valve is provided for use with a reactor. The valve includes a main body having a port therethrough. The valve also includes a sealing means disposed within the main body for sealing the port. An actuation means is provided in the valve for moving the sealing means axially, relative to the main body, between a first position, where the reactor is sealed, and a second position, where the reactor is unsealed.

These and other objects, features and advantages of the present invention will be more readily apparent from the detailed description of the preferred embodiments set forth below taken in conjunction with the accompanying drawings.

### BRIEF DESCRIPTION OF THE FIGURES

Figs. 1A and 1B are schematic illustrations of a side view and top view, respectively, of one embodiment of a semiconductor wafer processing system for use with the present invention;
Fig. 2 is a block diagram of an embodiment of an RTP reactor system in accordance with the present invention;
Fig. 3 is a simplified cross-sectional view of a reactor chamber as in Fig. 2, in accordance the principles of the present invention;
Fig. 4 is a simplified top view of an end effector with a wafer (shown in phantom) in accordance with the present invention;
Fig. 5 is a simplified schematic illustration of an embodiment of the present invention;
Fig. 6 is a simplified illustration of an embodiment of resistive heating elements in accordance with the present invention;
Fig. 6A is a simplified illustration of a portion of an embodiment of a resistive heating element of the present invention;
Figs. 6B-6D are simplified illustrations of embodiments of resistive heating elements in accordance with the present invention;
Figs. 7A-7C are various views of an embodiment of the compact gate valve assembly of the present invention;
Fig. 7D is a simplified illustration of force vectors acting upon the gate valve assembly of Figs. 7A-7C in accordance with one embodiment of the present invention; and
Fig. 8 is a simplified illustration of the embodiment of Fig. 3 showing temperature zones in accordance with the present invention.

### DETAILED DESCRIPTION

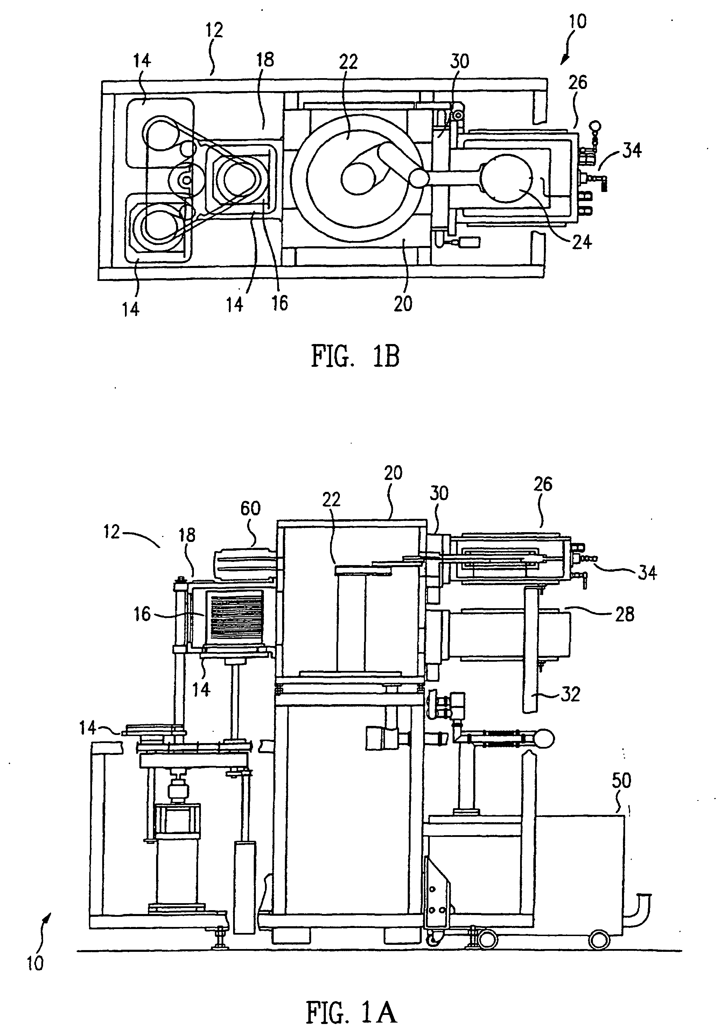

Figures 1A and 1B are schematic illustrations of a side view and top view, respectively, of one embodiment of a semiconductor wafer processing system 10 that establishes a representative environment of the present invention. The representative system is fully disclosed in co-pending U. S. patent application Serial No. 09/451,677. Processing system 10 includes a loading station 12 which has multiple platforms 14 for supporting and moving a wafer cassette 16 up and into a loadlock 18. Wafer cassette 16 may be a removable cassette which is loaded into a platform 14, either manually or with automated guided vehicles (AGV). Wafer cassette 16 may also be a fixed cassette, in which case wafers are loaded onto cassette 16 using conventional atmospheric robots or loaders (not shown). Once wafer cassette 16 is inside loadlock 18, loadlock 18 and transfer chamber 20 are maintained at atmospheric pressure or else are pumped down to a vacuum pressure using a pump 50. A robot 22 within transfer chamber 20 rotates toward loadlock 18 and picks up a wafer 24 from cassette 16. A reactor or thermal processing chamber 26, which may also be at atmospheric pressure or under vacuum pressure, accepts wafer 24 from robot 22 through a gate valve 30. Optionally, additional reactors may be added to the system, for example reactor 28. Robot 22 then retracts and, subsequently, gate valve 30 closes to begin the processing of wafer 24. After wafer 24 is processed, gate valve 30 opens to allow robot 22 to pick-up and place wafer 24 into cooling station 60. Cooling station 60 cools the newly processed wafers before they are placed back into a wafer cassette in loadlock 18.

In accordance with the present invention, reactors 26 and 28 are RTP reactors, such as those used in thermal anneals. In other embodiments, reactors 26 and 28 may also be other types of reactors, such as those used for dopant diffusion, thermal oxidation, nitridation, chemical vapor deposition, and similar processes. Reactors 26 and 28 are generally horizontally displaced, however in a preferred embodiment, reactors 26 and 28 are vertically displaced (i.e. stacked one over another) to minimize floor space occupied by system 10. Reactors 26 and 28 are bolted onto transfer chamber 20 and are further supported by a support frame 32. Process gases, coolant, and electrical connections may be provided through the rear end of the reactors using interfaces 34.

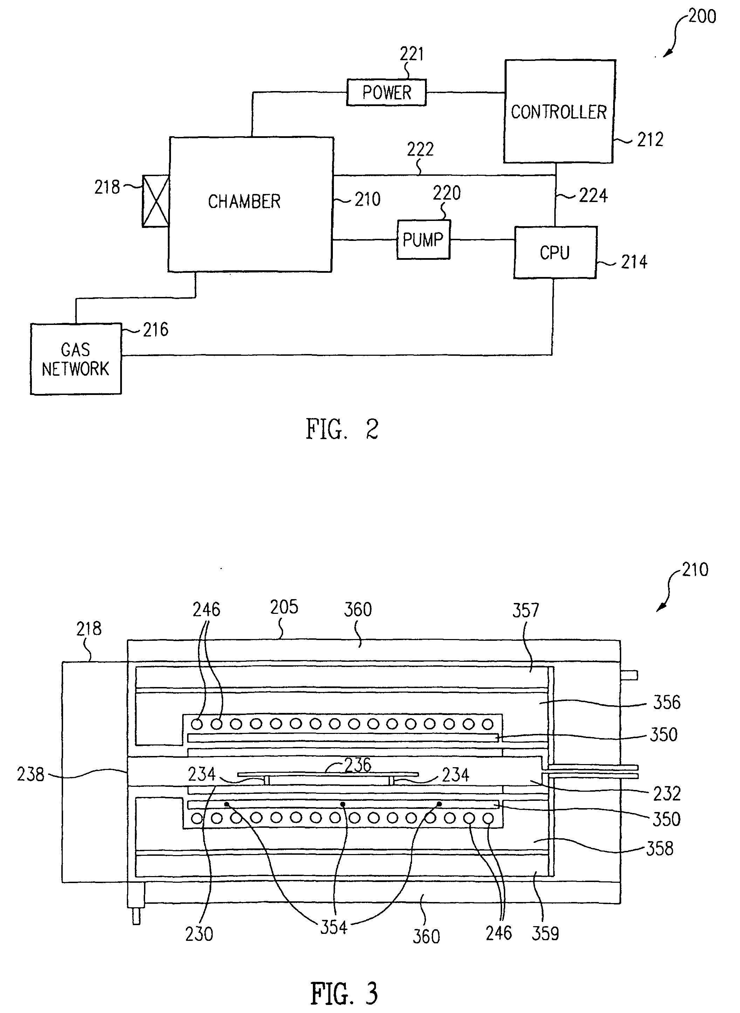

A simplified block diagram of an RTP reactor system of the present invention is shown in Fig. 2. In a preferred embodiment, reactor system 200 may include a reactor chamber 210, a controller 212, a process control computer 214, a gas network 216, a compact gate valve assembly 218, and a pump assembly 220. Each component of the system is described in greater detail below.

Referring now to Fig. 3, a simplified cross-sectional view of reactor chamber 210 is shown in accordance with one embodiment of the present invention. Externally, reactor chamber 210 may be a metallic shell 205, preferably made of aluminum or similar metal, having an opening provided on a face of shell 205, configured to receive a wafer for processing. Optionally, to protect users and/or equipment near chamber 210, the chamber may include thermal insulation layers 356, 357, 358, and 359. The layers may be made of any suitable insulation, such as a ceramic fiber material. Alternatively, a detachable water cooled jacket 360 or similar device may be used to surround chamber 210. The water cooled jacket 360 ensures that the reactor does not become too hot, so as to be a hazard to nearby equipment or personnel.

For ease of understanding, the embodiments of reactor chamber 210 shown in Fig. 3 are described as three sections. Each section has components grouped according to the general function performed by the particular section. The sections include: The processing chamber section, the heating section, and the wafer load/unload section.

As shown in Fig. 3, the processing chamber section may generally include a closed-end process chamber or tube 230, which defines an interior cavity 232. In one embodiment, tube 230 may be constructed with a substantially rectangular cross-section, having a minimal internal volume surrounding wafer 236. In this embodiment, the volume of tube 230 is usually no greater than 5000 cm³, preferably the volume is less than about 3000 cm³. One result of the small volume is that uniformity in temperature is more easily maintained. Additionally, the small tube volume allows reactor chamber 210 to be made smaller, and as a result, system 100 may be made smaller, requiring less clean room floor space. The smaller reactor size, in conjunction with the use of the robot loader, allows multiple reactors to be used in system 100 by vertically stacking the reactors as shown in Fig. 1A. Tube 230 is made of quartz, but may be made of silicon carbide, Al₂O₃, or other suitable material.

To conduct a process, quartz tube 230 should be capable of being pressurized. Typically, tube 230 should be able to withstand internal pressures of about 0.001 kg/cm² to 1000 kg/cm², preferably between about 0.1 kg/cm² and about 760 kg/cm².

In another embodiment, within tube 230 are wafer support standoffs 234, which support the single wafer 236. Standoffs 234 may be any high temperature resistant material, such as quartz. Standoffs 234 may have a height of between about 50 µm and about 20 mm. In order to monitor the temperature of wafer 236 during processing, at least one thermocouple may be embedded into at least one standoff 234.

An opening or aperture 238 at the left end of tube 230 provides access for the loading and unloading of wafer 236 before and after processing. Aperture 238 may be a relatively small opening, but with a height and width large enough to accommodate a wafer of between about 0.5 to 2 mm thick and up to about 300 mm (∼12 in.) in diameter, and robot arm 22 passing therethrough. The height of aperture 238 is no greater than between about 18 mm and 50 mm, and preferably, no greater than 20 mm. The relatively small aperture size helps to reduce radiation heat loss from tube 230. Also, the small aperture size keeps down the number of particles entering cavity 230 and allows for easier maintenance of the isothermal temperature environment. In one embodiment, during a processing procedure an edge of wafer 236 may be no less than 50 mm from aperture 238 when the wafer is placed on standoffs 234.

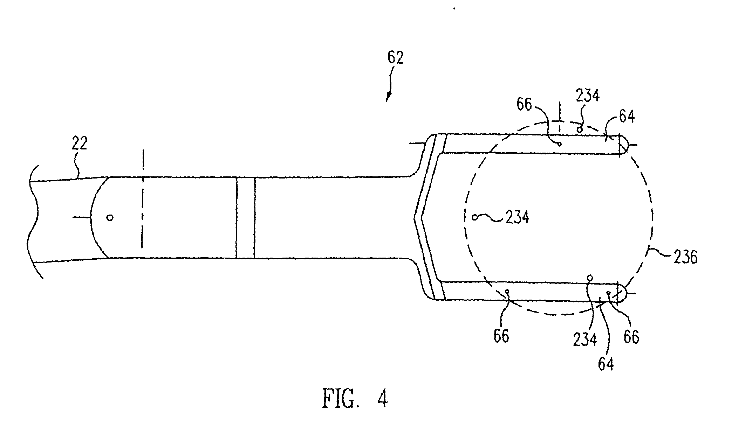

Fig. 4 is a simplified schematic illustration of robot arm 22 loading wafer 236 onto standoffs 234. As shown in Fig. 4, at the end of robot arm 22 is an end effector 62. In one embodiment, robot arm 22 urges end effector 62 through aperture 238 and subsequently lowers wafer 236 onto standoffs 234. To hold and transport wafer 236, end effector 62 may have any number of prongs 64, usually one or more, preferably two. Prongs 64 are sized and spaced apart from each other so that as end effector 62 enters tube 230, prongs 64 avoid contacting standoffs 234. Each prong 64 of end effector 62 has at least one wafer contact point 66. Preferably, end effector 62 has a total of at least three contact points. Contact points 66 are designed with a minimal surface area to provide a minimum of contact area between wafer 236 and contact points 66. In a preferred embodiment, the total contact area between contact points 66 and wafer 236 may be less than about 350 mm², preferably less than 300 mm².

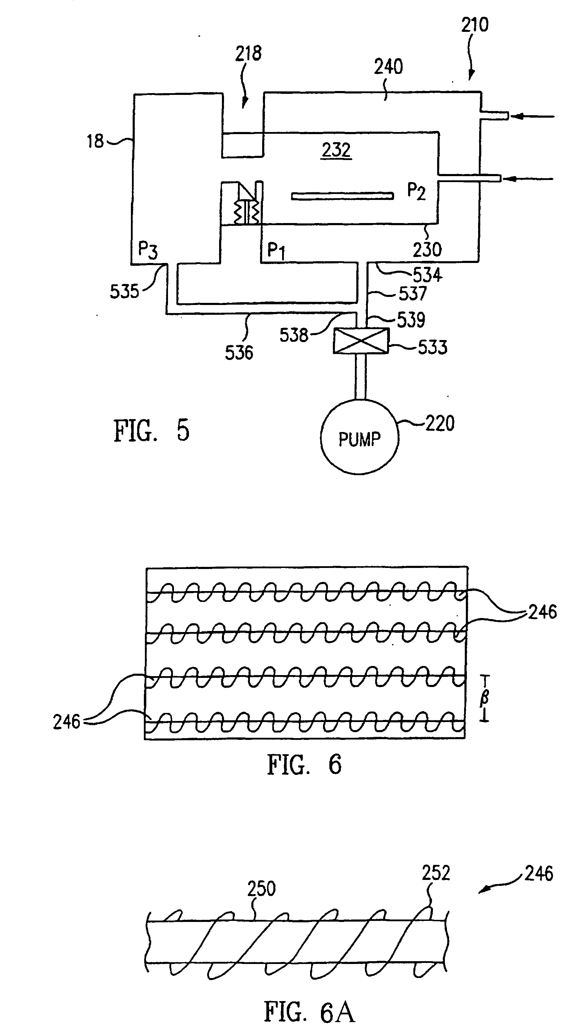

Figure 5 shows an alternative embodiment of reactor chamber 210, which may help to maintain the structural integrity of quartz tube 230 during high temperature processing. In this embodiment, an external cavity 240 may be formed around tube 230 and filled with air, or preferably, N₂, O₂, or other process gases. Using pure gases to fill the external cavity may help to extend the usage life of other components, such as heating elements, which may be housed in cavity 240. In a preferred embodiment, external cavity 240 may be maintained having at least an equal or lower pressure than interior cavity 232 (P₁≤P₂). In one embodiment, tube 230 may be in communication with loadlock 18, typically through gate valve 218, such that the pressure in tube 230 may be equal to the pressure in loadlock 18 (P₂=P₃). In this embodiment, the pressure differential between external cavity 240 and tube 230 creates a force on the internal walls of tube 230. To create the pressure differential external cavity 240 is evacuated directly at orifice 534 and through pump pipe 537. Tube 230 is evacuated through loadlock 18 at orifice 535 and through loadlock pipe 536. Pump pipe 537 and loadlock pipe 536 meet at tube intersection 538 and proceed as one pipe 539 to pump assembly 220. Since the combined volume of loadlock 18 and tube 230 is greater than the volume of external cavity 240, it follows that the pressure in external cavity 240 can be less than that in the combined loadlock 18 and tube 230 configuration. In this manner, the internal pressure in tube 230 can be used to fortify tube 230 against failure, and ensures that the structural integrity of tube 230 is maintained.

Pump assembly 220 may include any suitable pump for creating the required process pressures within chamber 210. Pump assembly 220 may also serve other purposes, as are generally required of a pump in a processing system. For example, pump assembly 220 may be used to pump down or create a vacuum in process chamber 230, such that the cool down rate within the chamber can be controlled. An exemplary pump assembly may include mechanical pump model HC-60B available from Kashiyama Industries Ltd.

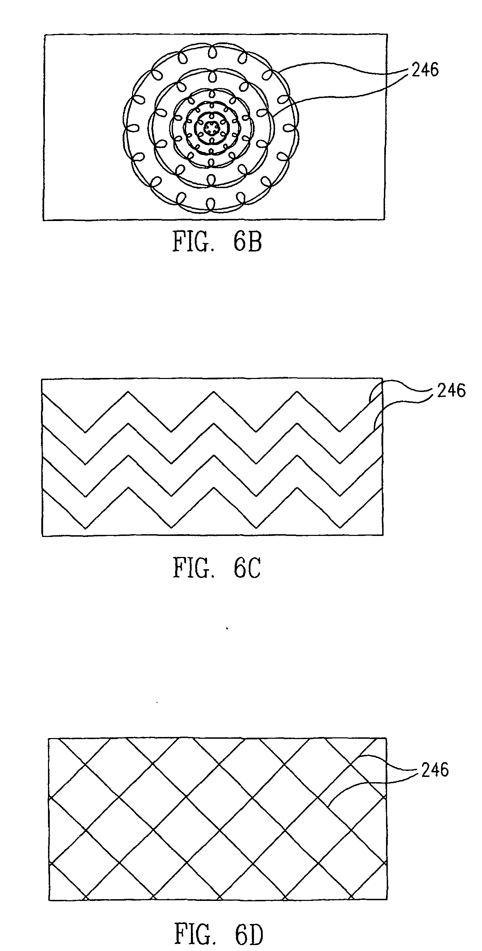

Referring again to Fig. 3, the heating section of the present invention is configured to surround the process chamber section. The heating section includes heating elements, preferably resistive heating elements 246. In a preferred embodiment, a plurality of heating elements 246 are used to surround a top and a bottom portion of tube 230. In one embodiment, shown in Fig. 6, resistive heating elements 246 may be disposed in parallel across chamber 210. Each element 246 is in relative close proximity to each other element. For example, each resistive heating element 246 may be spaced a distance β from the next closest heating element, which may be between about 5 mm and 50 mm, preferably between about 10 mm and 20 mm. Accordingly, the close spacing of heating elements 246 provides for an even heating temperature distribution across the wafer positioned in cavity 232.

Fig. 6A shows an exemplary heating element 246, in accordance with the principles of the present invention. Resistive heating element 246 includes a resistive heating element core 250 and a filament wire 252. Core 250 is usually made of a ceramic material, but may be made of any high temperature rated, non-conductive material. Filament wire 252 is conventionally wrapped around core 250 to allow for an optimal amount of radiated heat energy to emanate from the element. Filament wire 252 may be any suitable resistively heatable wire, which is made from a high mass material for increased thermal response and high temperature stability, such as SiC, SiC coated graphite, graphite, NiCr, AlNi and other alloys. Preferably, resistive heating filament wire 252 is made of a combination Al-Ni-Fe material, known commonly as Kantal A-1 or AF, available from Omega Corp. of Stamford, Connecticut.

Optionally, as shown in Figs. 6B-6D, resistive heating elements 246 may be positioned in various configurations which may include, for example, circular, zigzag, cross-hatched patterns and the like. The variable patterns may be able to provide more optimal temperature distribution and further reduce the possibility of temperature fluctuations across the surface of the wafer. Advantageously, a direct line voltage of between about 100 volts and about 500 volts may be used to power the resistive elements. Thus, no complex power transformer is needed in the present invention for controlling the output of resistive heating elements 246.

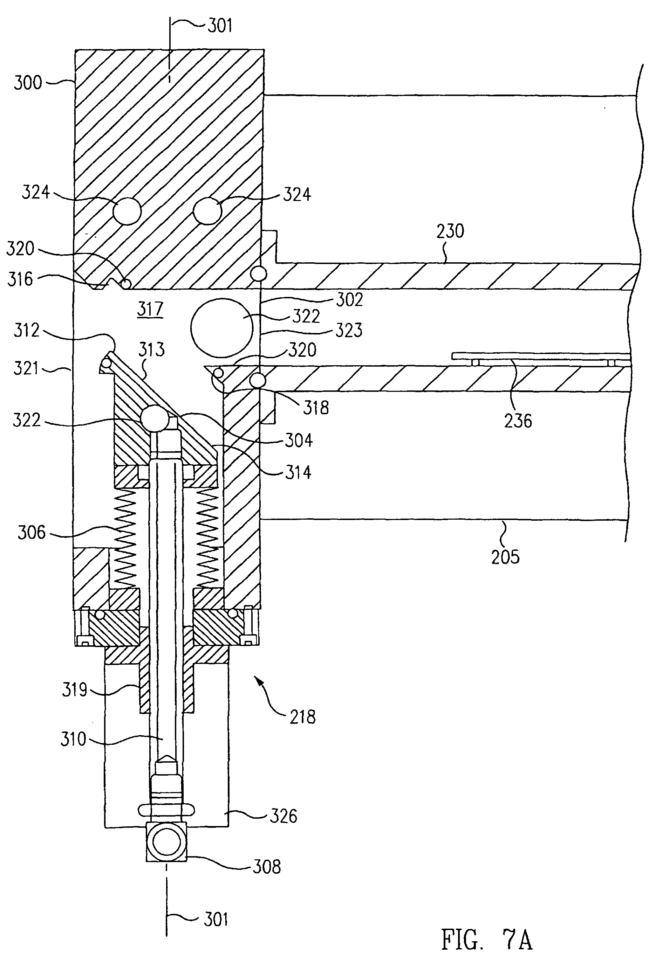

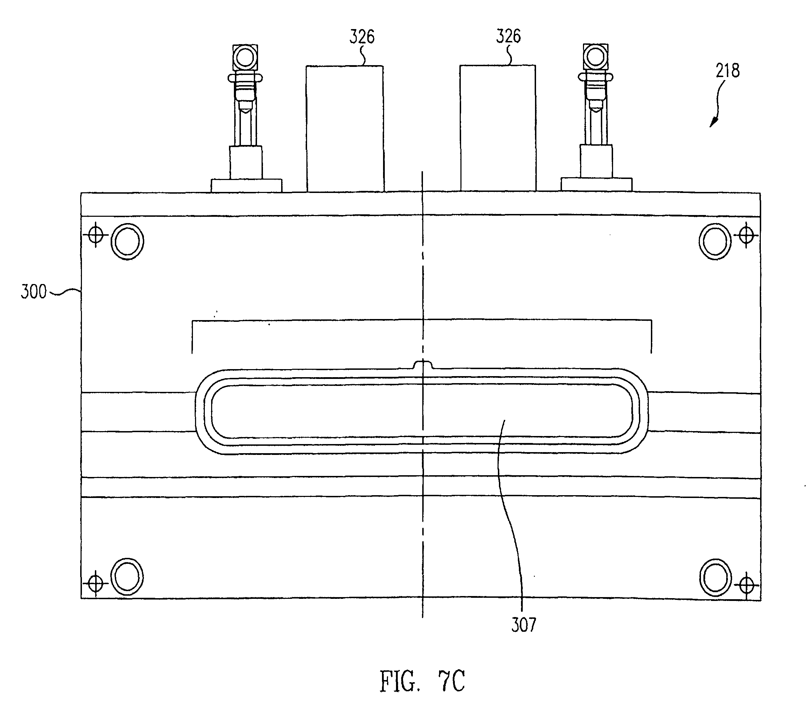

Referring to Figs. 7A-7D and once again to Fig. 3, the loading/unloading section of chamber 210 includes gate valve assembly 218, which is generally coupled to external shell 205 at aperture 238. Housed within gate valve main body 300 and aligned along the valve central axis 301 are gate 304, bellows 306, plumbing interface 308, linear drive shaft 310, and actuator 326, all assembled together to provide gate valve assembly 218. In a preferred embodiment, valve main body 300 defines a port 317. Port 317 has a first end 321, which provides initial access to the reactor through gate valve 218, and a second end 323, which has an aperture or opening 302 configured to mate with aperture 238 of quartz tube 230. The geometry and dimensions of valve aperture 302 generally correspond to those of reactor aperture 238, so that valve aperture 302 and reactor aperture 238 can be used together to provide a seal, which maintains a selected vacuum or pressurized environment within tube 230 or isolates cavity 232 during wafer processing operations.

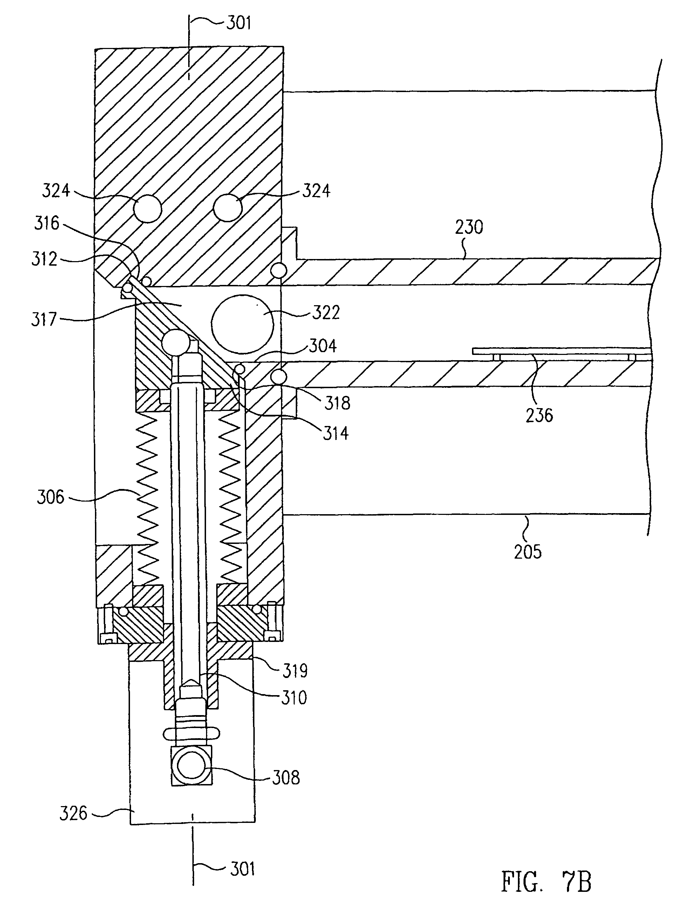

Gate 304 is an elongated plate mounted at an upper end of drive shaft 310. The elongated plate is well suited for sealing slot-type openings, such as valve aperture 302. It should be understood that the geometry of gate 304 may be changed to accommodate differently shaped openings. Preferably, as shown in Figs. 7A and 7B, gate 304 may be sloped relative to central axis 301 to form inclined surface 313. Inclined surface 313 may be sloped at any angle, such as between about 5° and about 85°, which is adequately suited to allow for the proper performance of the present invention. In a preferred embodiment, inclined surface 313 is angled at between about 30° and about 60°, more preferably about 45° to axis 301. On a top and bottom portion of inclined surface 313 are contact portions 312 and 314, which extend along the elongated length of gate 304. In a preferred embodiment, inclined surface 313 may have a highly polished surface or may be coated with a heat/radiation reflective coating, such as gold, silver, Ni, Molybdenum, or other metal with a high melting point relative to the process temperatures. The reflective surface may reflect radiation energy, which may leak through valve aperture 302, back into tube 230.

By way of example, when drive shaft 310 is moved up into main body 300, gate 304 is moved upward, into port 317 (Fig. 7B). Drive shaft 310 is moved up and/or down through linear guide 319 by a linear action created using actuator 326. In the preferred embodiment, to move drive shaft 310, actuator 326 is supplied at plumbing interface 308 with a conventional incompressible fluid, such as water or alcohol. The supply of fluid causes drive shaft 310 to move linearly through linear guide 319 into main body 300.

By moving linear shaft 310 vertically upward, as described in Fig. 7A, linear shaft 310 drives the expansion of bellows 306. Bellows 306 surrounds shaft 310 along axis 301. In this embodiment, bellows 306 establishes a vacuum seal between actuator 326 and main body 300 to ensure that tube 230 is not contaminated from the outside environment during opening and closing of the valve.

As shown in Fig. 7D, when linear shaft 310 reaches the end of its effective travel length (See Fig. 7B), portions 312 and 314 of gate 304 contact sealing surfaces 316 and 318, respectively, with a force F to create the positive seal, which isolates tube 230. Inclined surface 313 causes force F to create reaction forces Rx and Ry at contact surfaces 316 and 318. The reaction force Rx acts equally on contact surfaces 316 and 318, as shown in Fig. 7D, normal to inclined surface 313. It should be understood that the horizontal force component Rx, which provides the sealing force that causes gate 304 to form a positive seal with contact surfaces 316 and 318 at opening 302. Beneficially, since the sealing force can be provided without the need for a horizontal action or horizontal movement of shaft 310 or gate 304, gate valve 218 may be designed with a reduced profile and size. It is another advantage of the present invention that when a vacuum is drawn in tube 230, outside pressure forces the inclined surface 313 against contact surfaces 316 and 318 and O-ring 320 to create the seal. Because of the O-ring, sliding contact between the inclined surface 313 and the contact surfaces 316 and 318 is substantially avoided. The portions of inclined surface 313 which may contact the gate main body, may also be coated with a soft buffer material to avoid metal-to-metal sliding contact, which helps to avoid the creation of contaminating particles.

To re-open the valve from the closed configuration, gate 304 is removed from bore 317 when drive shaft 310 is moved down and out from main body 300 through linear guide 319 (Fig. 7A) by actuator 326, thus removing the sealing force from gate 304 to open bore 317 for loading/unloading of the wafer.

Additionally, gate valve 218 also has an exhaust port 322, which allows for controlling of the process chamber pressure. Also, cooling fluid ports 324 are provided, which allow a coolant to flow so as to reduce the external temperature of the gate valve main body during RTP.

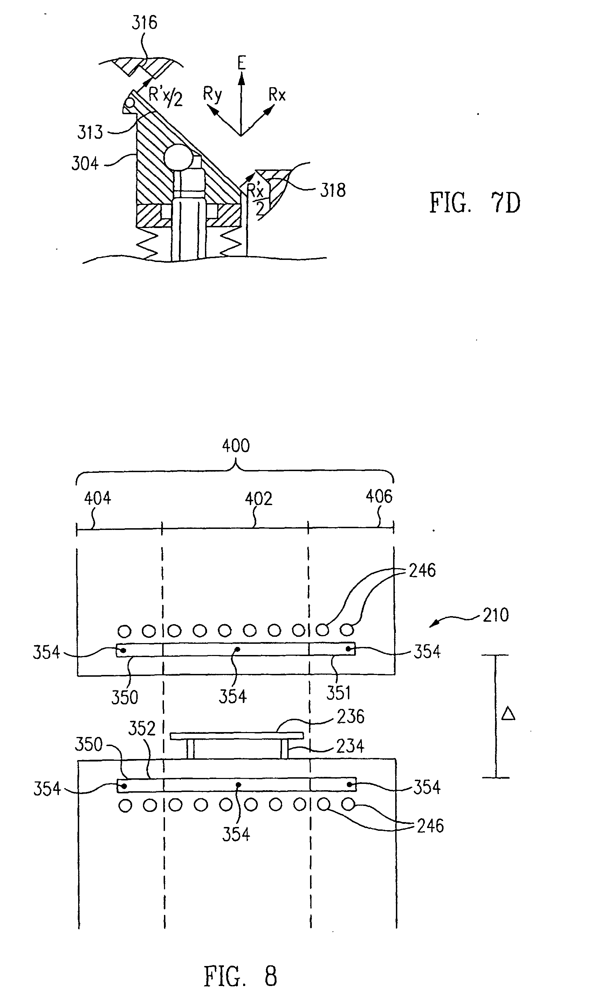

As better understood with reference to Fig. 8, in conjunction with Fig. 2, in a preferred embodiment, reactor chamber 210 may include up to any number of heating zones 400. In the embodiment shown in Fig. 8, reactor chamber 210 has three parallel heating zones, which includes a central zone 402 and two adjacent outer zones 404 and 406. In an alternative embodiment, shown in Fig. 6B, the heating elements may be in a circular configuration and therefore may include at least two heating zones, a central inner zone and an outer zone. Referring again to Fig. 8, each heating element 246 can be apportioned to a specific heating zone 402, 404, and 406. As described in more detail below, each heating zone 402, 404, and 406 has at least one temperature sensor 354, which provides feedback to controller 212. Accordingly, as fluctuations in temperature within a heating zone 402, 404, and/or 406 are sensed by temperature sensors 354, real-time controller 212 (Fig. 2) can cause the power from power supply 221 (Fig. 2) to increase or decrease, as necessary, to increase or decrease the energy output (heat) from each of resistive elements 246. For example, if a drop in temperature is sensed in zone 404, the thermal energy output from resistive heating elements 246 apportioned to zone 404, increases until the temperature in zone 404 is returned to the desired level. In this manner, the temperature from zone-to-zone across the surface of wafer 236 may be kept substantially isothermal.

The number of resistive elements 246 apportioned to each zone may vary based on the energy output desired per zone. The size of each zone (i.e. the heating volume) is also variable. In a preferred embodiment, central zone 402 can encompass at least one wafer of up to about 300 mm in diameter. For example, as shown in Fig. 8, when placed on standoffs 234, wafer 236 is fully within the boundary of zone 402 as indicated by the dashed lines. Advantageously, the size of each zone can be scaled up or down as desired. For example, zone 402 can be scaled up for processing of larger wafers, by re-apportioning heating elements 246 from zone 404 to zone 402. This means that the number of heating elements 246 assigned to zone 402 is increased, while the number of heating elements assigned to zone 404 is decreased. The heating elements added to zone 402 are controlled by controller 212 (Fig. 2) to respond in the same manner as the heating elements already assigned to zone 402.

In yet another embodiment, shown in Figs. 3 and 8, chamber 210 includes heat diffusing members 350, which are positioned proximate to and typically overlay heating elements 246. Heat diffusing members 350 absorb the thermal energy output from heating elements 246 and dissipate the heat evenly within tube 230. It should be appreciated that by heating wafer 236 from above and below, and further by keeping the distance Δ between heat diffusing members 350 small, the temperature gradient within tube 230 is more easily isothermally maintained. For example, if top heat diffusing member 351 is maintained at 1000°C and bottom heat diffusing member 352 is also maintained at 1000°C, the temperature gradient in the small space between them should also be substantially maintained at 1000°C with very little fluctuation. Heat diffusing members 350 may be any suitable heat diffusing material that has a sufficiently high thermal conductivity, preferably Silicon Carbide, Al₂O₃, or graphite. In a preferred embodiment, temperature sensors 354, preferably thermocouples, are embedded within heat diffusing members 350. Thermocouples 354 are strategically placed such that they can provide feedback as to the temperature conditions of the heat diffusing members. For example, at least one thermocouple 354 is placed at each end and at the center of heat diffusing members 351 and 352. In this configuration, the temperature of each zone 402, 404, and 406 can be monitored with feedback provided to controller 212 (Fig. 2). By positioning the thermocouples 354 at known positions on the heat diffusing members 350, the temperature gradient can be determined with reference to a position within tube 230. This data is used by controller 212 to control the temperature within each zone 402, 404, and 406 more precisely. Thermocouples 354 are conventional R-type or K-type thermocouples available from Omega Corporation of Stamford, Connecticut.

A microprocessor or process control computer 214, generally controls the processing of a semiconductor wafer placed in the RTP reactor and may be used to monitor the status of the system for diagnostic purposes. In one embodiment, process computer 214 provides control signals to controller 212 in response to temperature data received from temperature sensors 354 in chamber 210. Process computer 214 may also direct pressure setpoints to pump assembly 220 as well as gas and plasma inlet flow signals to mass-flow controllers in gas network 216. In one embodiment, controller 212 is a real-time Proportional Integral Derivative (PID), multi-zone controller, available from Omega Corporation. Controller 212 provides control signals to a SCR-based phase controlled power supply 221, which provides power to the resistive heating elements provided in chamber 210. In operation, the multi-zone controller receives temperature sensor outputs via sensing line 222 from chamber 210, as well as the desired wafer temperature setpoint from computer 214 via line 224 and delivers controlled power setpoints to the heating element power supply 221. As described in greater detail below, the heating elements increase or decrease their energy output in response to the increase or decrease in power supplied from power supply 221.

A primary advantage of the present invention is the ability to conduct substantially slip free RTP of a silicon wafer. The advantages of embodiments of the present invention will be further understood by reference to the following parameters, which are provided below to illustrate the present invention and not to limit or restrict it.

In one exemplary embodiment, in order to conduct substantially slip-free RTP in chamber 210 in accordance with the present invention, the following parameters should be used. A wafer having a diameter of 150 mm or greater is loaded into the processing chamber of the present invention. The wafer is loaded using an end effector that has one or more wafer contact points with a cumulative contact point area no greater than 300 mm². The loading/unloading speed of the wafer is done between about 50 mm/s and about 600 mm/s in the horizontal plane and between about 5 mm/s and about 100 mm/s in the vertical plane. The wafer is placed on one or more standoffs positioned within the chamber. The standoffs will generally have a height of between about 50 µm and about 20 mm. The total contact area between the standoffs and the wafer is less than about 350 mm², preferably less than about 300 mm². The processing may occur at temperatures between about 900 °C and 1200 °C, preferably between 1000 °C and 1200 °C, at a chamber pressure of between 0.1 kg/cm² and about 1000 kg/cm², preferably at atmospheric pressure.

It should be understood that the wafer described above may be made of conventional materials commonly used in the industry, such as silicon, gallium arsenide, or other similar compound or the wafer may be a semiconductor wafer, made from quartz or glass.

Having thus described the preferred embodiments, persons skilled in the art will recognize that changes may be made in form and detail without departing from the scope of the invention. Thus the invention is limited only by the following claims.

## Claims

1. A valve assembly (218) for use with a rapid thermal processing reactor, the valve assembly comprising:
a main body(300) defining a flow path through a bore (317) configured to receive a semiconductor substrate (236), a central axis (301) perpendicular to said flow path and a contact sealing surface (316, 318) including a gasket (320);
a gate(304) having a single-planer inclined surface relative to said central axis and including a contact portion (312, 314), said gate disposed within said main body (300); and
an actuation assembly (326) for linearly moving said gate along said central axis perpendicular to said flow path between a first position where said contact portion (312, 314) is away from said contact sealing surface (316, 318) and a second position where said contact portion (312, 314) substantially contacts said contact sealing surface (316, 318) along a plane defined by a surface of said single-planer inclined surface (313).

2. The valve assembly of Claim 1, wherein said inclined surface (313) is coated with a radiation reflecting material.

3. The valve assembly of Claim 2, wherein said coating comprises a material selected from the group consisting of gold, silver, Ni, and Molybdenum.

4. The valve assembly of Claim 1, wherein said inclined surface (313) comprises a slope from between about 30° and about 60° relative to said central axis.

5. The valve assembly of Claim 1, wherein said actuation assembly (326) comprises an expandable member, expandable along said central axis.

6. The valve assembly of Claim 5, wherein said expandable member (310) comprises a bellows (306).

7. The valve assembly of Claim 5, wherein said actuation assembly (326) comprises a translatable linear shaft (310) which moves axially relative to said main body (300) in response to expansion of said expandable member.

8. The valve assembly of Claim 5, wherein said actuation assembly (326) comprises a fluid inlet which provides a means for expanding said expandable member.

9. The valve assembly of Claim 1, wherein said gasket (320) comprises an O-ring.

## Patentansprüche

1. Ventilbaugruppe (218) zur Verwendung in einem Reaktor zum schnellen thermischen Verarbeiten, wobei die Ventilbaugruppe Folgendes umfasst:
einen Hauptkörper (300), der Folgendes abgrenzt: einen Strömungspfad durch eine Bohrung (317), die so konfiguriert ist, dass sie ein Halbleitersubstrat (236) aufnimmt, eine Mittelachse (301) senkrecht zu dem Strömungspfad und eine Kontaktdichtfläche (316, 318), die eine Dichtung (320) umfasst;
einen Absperrschieber (304), der eine geneigte Oberfläche mit einer einfachen Ebene im Verhältnis zu der Mittelachse aufweist und der einen Kontaktabschnitt (312, 314) umfasst, wobei der Absperrschieber in dem Hauptkörper (300) angeordnet ist; und
eine Betätigungsbaugruppe (326) zur linearen Bewegung des Absperrschiebers entlang der Mittelachse senkrecht zu dem Strömungspfad zwischen einer ersten Position, in der der Kontaktabschnitt (312, 314) von der Kontaktdichtfläche (316, 318) entfernt angeordnet ist, und einer zweiten Position, in der der Kontaktabschnitt (312, 314) die Kontaktdichtfläche (316, 318) entlang einer Ebene, die durch eine Fläche der geneigten Oberfläche (313) mit einer einfachen Ebene abgegrenzt wird, im Wesentlichen berührt.

2. Ventilbaugruppe nach Anspruch 1, wobei die geneigte Oberfläche (313) mit einem strahlungsreflektierenden Material beschichtet ist.

3. Ventilbaugruppe nach Anspruch 2, wobei die Beschichtung ein Material umfasst, das aus der Gruppe bestehend aus Gold, Silber, Ni und Molybdän ausgewählt wird.

4. Ventilbaugruppe nach Anspruch 1, wobei die geneigte Oberfläche (313) eine Neigung zwischen etwa 30° und etwa 60° im Verhältnis zu der Mittelachse aufweist.

5. Ventilbaugruppe nach Anspruch 1, wobei die Betätigungsbaugruppe (326) ein ausfahrbares Element umfasst, das entlang der Mittelachse ausfahrbar ist.

6. Ventilbaugruppe nach Anspruch 5, wobei das ausfahrbare Element (310) einen Faltenbalg (306) umfasst.

7. Ventilbaugruppe nach Anspruch 5, wobei die Betätigungsbaugruppe (326) eine verschiebbare Linearwelle (310) umfasst, die sich als Reaktion auf das Ausfahren des ausfahrbaren Elements im Verhältnis zu dem Hauptkörper (300) axial bewegt.

8. Ventilbaugruppe nach Anspruch 5, wobei die Betätigungsbaugruppe (326) einen Fluideinlass umfasst, der ein Mittel für das Ausfahren des ausfahrbaren Elements bereitstellt.

9. Ventilbaugruppe nach Anspruch 1, wobei die Dichtung (320) einen O-Ring umfasst.

## Revendications

1. Ensemble soupape (218) à utiliser avec un réacteur de traitement thermique rapide, cet ensemble soupape comprenant :
un corps principal (300) définissant une voie de passage à travers un alésage (317) configuré pour recevoir un substrat de semi-conducteur (236), un axe central (301) perpendiculaire à ladite voie de passage et une surface d'étanchéité par contact (316, 318) comportant un joint statique (320) ;
une vanne (304) ayant une surface inclinée dans un seul plan par rapport audit axe central et comprenant une portion de contact (312, 314), ladite vanne étant disposée à l'intérieur du corps principal (300) ; et
un ensemble d'actionnement (326) pour déplacer linéairement ladite vanne le long dudit axe central perpendiculairement à ladite voie de passage entre une première position où ladite portion de contact (312, 314) est écartée de ladite surface d'étanchéité par contact (316, 318) et une deuxième position où ladite portion de contact (312, 314) entre en contact dans une large mesure avec ladite surface d'étanchéité par contact (316, 318) le long d'un plan défini par une surface de ladite surface inclinée dans un seul plan (313).

2. L'ensemble soupape de la revendication 1, dans lequel ladite surface inclinée (313) est revêtue d'un matériau reflétant le rayonnement.

3. L'ensemble soupape de la revendication 2, dans lequel ledit revêtement comprend un matériau sélectionné dans le groupe constitué par l'or, l'argent, le nickel et le molybdène.

4. L'ensemble soupape de la revendication 1, dans lequel ladite surface inclinée (313) comporte une pente à un angle situé entre environ 30° et environ 60° par rapport audit axe central.

5. L'ensemble soupape de la revendication 1, dans lequel ledit ensemble d'actionnement (326) comporte un élément expansible, qui est expansible le long dudit axe central.

6. L'ensemble soupape de la revendication 5, dans lequel ledit élément expansible (310) comporte un soufflet (306).

7. L'ensemble soupape de la revendication 5, dans lequel ledit ensemble d'actionnement (326) comporte un arbre linéaire pouvant être translaté (310) qui se déplace axialement par rapport au corps principal (300) en réponse à l'expansion dudit élément expansible.

8. L'ensemble soupape de la revendication 5, dans lequel ledit ensemble d'actionnement (326) comporte une entrée de fluide qui fournit un moyen pour mettre en expansion ledit élément expansible.

9. L'ensemble soupape de la revendication 1, dans lequel ledit joint statique (320) comporte un joint torique.
